# EUROPÄISCHE PATENTSCHRIFT

(11) **EP 1 979 910 B1**
(45) Veröffentlichungstag und Bekanntmachung des Hinweises auf die Patenterteilung: **18.05.2011**
(21) Anmeldenummer: 07802731.5
(22) Anmeldetag: 20.08.2007
(51) Int. Cl.: G11C 5/14, G11C 5/00, G07C 5/08, G01C 22/02

(54) **VERFAHREN UND VORRICHTUNG ZUR STEUERUNG EINES ZUGRIFFS AUF EINEN DATENSPEICHER IN EINER ELEKTRONISCHEN SCHALTUNG**
METHOD AND APPARATUS FOR CONTROLLING ACCESS TO A DATA STORE IN AN ELECTRONIC CIRCUIT
PROCEDE ET DISPOSITIF POUR COMMANDER UN ACCES A UNE MEMOIRE DE DONNEES DANS UN CIRCUIT ELECTRONIQUE

(30) Priorität: 21.08.2006 DE 102006038967; 13.08.2007 DE 102007038226
(43) Veröffentlichungstag der Anmeldung: 15.10.2008
(73) Patentinhaber: Continental Automotive GmbH, 30165 Hannover (DE)
(72) Erfinder: HOFFMANN, Klaus, 78050 Villingen-Schwenningen (DE); LITTWIN, Jürgen, 78056 Villingen-Schwenningen (DE); NÄTHER, Horst, 78052 Villingen-Schwenningen (DE); OBERGFELL, Armin, 78086 Brigachtal (DE)
(86) Internationale Anmeldenummer: PCT/EP2007/058632
(87) Internationale Veröffentlichungsnummer: WO 2008/022992

(56) Entgegenhaltungen:
- WO-A-85/04723
- JP-A- 6 082 266
- US-A- 5 046 029

## Beschreibung

Die Erfindung bezieht sich auf ein Verfahren, insbesondere in einem Tachographen für ein Kraftfahrzeug, zur Steuerung eines Zugriffs auf einen einen ersten Speicherbereich und einen zweiten Speicherbereich aufweisenden Datenspeicher in einer elektronischen Schaltung. Außerdem bezieht sich die Erfindung auf eine Vorrichtung, insbesondere einen Tachographen für ein Kraftfahrzeug, zur Durchführung des vorgenannten Verfahrens mit einer einen Datenspeicher aufweisenden elektronischen Schaltung.

Ein vorgenanntes Verfahren und eine vorgenannte Vorrichtung sind beispielsweise von einem Mikrocomputer mit einem Mikroprozessor als Zentraleinheit, einem Hauptspeicher als Datenspeicher und einer Ein-/Ausgabeeinheit bekannt. Der Mikroprozessor weist einen ausführenden Teil und einen steuernden Teil auf, wobei der steuernde Teil während eines Befehlszyklus einen Befehl aus dem Hauptspeicher ausliest, der durch ein Programm vorgegeben ist; die Befehlsausführung geschieht dann in dem ausführenden Teil des Mikroprozessors. Der Hauptspeicher kann verschiedene Speicherbereiche zur Speicherung von Daten aufweisen. In dem Hauptspeicher können nicht nur Befehle in Form von Daten abgelegt und ausgelesen werden, sondern auch beliebige andere Daten, zum Beispiel Betriebszustände des Mikrocomputers und/oder manuell über die Ein-/Ausgabeeinheit in den Mikrocomputer eingegebene, beispielsweise personenbezogene, Daten. Allgemein ist der Prozessor eine Recheneinheit eines Computers, welche Recheneinheit andere Bestandteile des Computers mittels Software steuert.

Weiterhin ist für ein Kraftfahrzeug, insbesondere ein Nutzfahrzeug, ein digitaler Tachograph bekannt, der unter anderem einen Chipkartenleser zur Aufnahme einer Fahrerkarte, einen als Massenspeicher, beispielsweise batteriegepuffertes RAM (random access memory), ausgebildeten Datenspeicher und eine elektronische Schaltung, die von einem Prozessor gesteuert wird, umfasst. In dem Massenspeicher werden beispielsweise von Sensoren und/oder durch manuelle Eingabe erfasste Daten fahrer- und fahrzeugbezogen gespeichert. Bei einem Ausfall einer elektrischen Spannungsversorgung besteht die Gefahr eines zumindest unerwünschten, wenn nicht gar unzulässigen Verlustes und/oder einer entsprechenden Beschädigung der in dem Massenspeicher abgelegten Daten.

Aus WO 85/04723 A1 ist eine Stromversorgung und ein Leistungsmonitor für einen elektrischen Zähler bekannt. Für den elektrischen Zähler ist ein Verfahren zur Steuerung eines Zugriffs auf einen nichtflüchtigen Speicher und einen flüchtigen Datenspeicher eines Prozessors beschrieben.

Ferner ist aus JP 06-082266 A ein Wegstreckenzähler mit einer Speicherkomponente bekannt, der einen Kondensator zur Reservestromversorgung aufweist. Einen Wegstreckenzähler mit einem nichtflüchtigen Speicher offenbart US 5 046 029 A.

Der Erfindung liegt die Aufgabe zugrunde, ein Verfahren der eingangs genannten Art anzugeben, das eine erhöhte Datensicherheit gewährleistet. Darüber hinaus liegt der Erfindung die Aufgabe zugrunde, eine Vorrichtung der eingangs genannten Art zu schaffen, die eine erhöhte Datensicherheit gewährleistet und zur Durchführung eines vorgenannten Verfahrens geeignet ist.

Die erstgenannte Aufgabe wird erfindungsgemäß gelöst mit einem Verfahren der eingangs genannten Art, wobei der erste Speicherbereich zur Speicherung von mit einer höheren Sicherheit zu schützenden Daten und der zweite Speicherbereich zur Speicherung von mit einer niedrigeren Sicherheit zu schützenden Daten vorgesehen ist, wobei eine Versorgungsspannung gemessen wird und wobei bei einer Versorgungsspannung unterhalb einer vorgegebenen ersten Spannungsschwelle der Zugriff auf den ersten Speicherbereich gesperrt ist.

Bevorzugt wird dabei als Versorgungsspannung eine Versorgungsspannung des Datenspeichers oder einer Datenverarbeitungseinrichtung der elektronischen Schaltung gemessen. Vorzugsweise kann der erste Speicherbereich ein Datensicherheit gewährleistender Speicherbereich und der zweite Speicherbereich ein Speicherbereich ohne Datensicherheit sein. Dieses ist zum Beispiel bei einem Tachographen für ein Kraftfahrzeug von Vorteil, wobei zu schützende Tachographendaten in dem ersten Speicherbereich und nicht zu schützende Tachographendaten in dem zweiten Speicherbereich abgelegt werden. Von besonderem Vorteil ist bei dem erfindungsgemäßen Verfahren, dass in Abhängigkeit der gemessenen Versorgungsspannung ein Sperren des ersten Speicherbereichs erfolgt; dazu wird die gemessene Versorgungsspannung, vorzugsweise des Datenspeichers oder der Datenverarbeitungseinrichtung, insbesondere eines Mikroprozessors oder Mikrocontrollers der Datenverarbeitungseinrichtung, der elektronischen Schaltung, mit der ersten Spannungsschwelle verglichen und in Abhängigkeit von dem Vergleich gegebenenfalls der Zugriff auf den ersten Speicherbereich gesperrt. Daten in dem ersten Speicherbereich, die eines höheren Schutzes insbesondere gegen Beschädigung und/oder Zerstörung und/oder unkontrollierte Veränderung bedürfen als diejenigen des zweiten Speicherbereichs, sind somit zuverlässig vor Beschädigung und Zerstörung bei einem Ausfall und/oder einem unzulässig starken Abfall der Versorgungsspannung geschützt. Dass die erste Spannungsschwelle vorgegeben ist bedeutet, dass sie zum Zeitpunkt des Vergleichs der gemessenen Versorgungsspannung mit dem Wert der ersten Spannungsschwelle festgelegt ist; die erste Spannungsschwelle kann aber grundsätzlich veränderbar, das heißt variabel, zum Beispiel vor einer Messung oder vor einem Starten des erfindungsgemäßen Verfahrens einstellbar, sein. Die elektronische Schaltung kann bei dem erfindungsgemäßen Verfahren zum Beispiel von einem Prozessor oder von einem logischen Array oder Gatter gesteuert werden. Vorzugsweise erfolgt die Messung der Versorgungsspannung des Datenspeichers in einer Endlosschleife, die auch dann nicht unterbrochen wird, wenn der Zugriff auf den ersten Speicherbereich gesperrt ist. Während des Sperrens des Zugriffs auf den ersten Speicherbereich verharrt das erfindungsgemäße Verfahren vorzugsweise in einem Zustand, den man als Halt-Mode bezeichnen kann.

Besonders vorteilhaft ist das erfindungsgemäße Verfahren für einen digitalen Tachographen, der ein elektronisches Registriergerät zum Sammeln und Auswerten von Daten ist und eine elektronische Schaltung mit einer zentralen Verarbeitungseinheit und einem als Massenspeicher, insbesondere als - vorzugsweise batteriegepuffertes - RAM, ausgebildeten Datenspeicher aufweist. Zumindest ein Teil von in dem Massenspeicher gespeicherten Daten sind besonders schützenswert und müssen über einen längeren Zeitraum gesammelt und vorgehalten werden. Der übliche Einsatzort des Tachographen in einem Kraftfahrzeug erfordert jedoch einen hohen Schutz gegen Spannungsausfälle und -störungen, die beim Betrieb des Tachographen in kritisch niedrigen Spannungsbereichen auftreten können. Hier schafft die Erfindung Abhilfe. Die Erfindung kann insbesondere auch undefinierte Zustände auf Daten- und Adressleitungen des Massenspeichers verhindern, die zu einem Überschreiben von Datenbereichen führen könnten und im schlimmsten Fall sogar den Tachographen unbrauchbar machen könnten. Mit dem erfindungsgemäßen Verfahren wird in einem kritischen Spannungsbereich, der durch die erste Spannungsschwelle festgelegt ist, der Versorgungsspannung, vorzugsweise der Versorgungsspannung des Datenspeichers oder der Datenverarbeitungseinrichtung, der Zugriff auf den besonders zu schützenden, ersten Speicherbereich, der die wichtigsten gespeicherten Daten enthält, gesperrt. Die Zugriffsfunktionalität wird dabei angehalten und das den Tachographen steuernde Programm verharrt in einer Schleife entsprechend dem oben genannten Halt-Mode. Dabei ist nur noch ein Zugriff auf einen nicht oder zumindest weniger schützenswerten Speicherbereich, nämlich den zweiten Speicherbereich, möglich.

Gemäß einer vorteilhaften Weiterbildung der Erfindung wird die Versorgungsspannung kontinuierlich gemessen. Somit kann auf einen Spannungsaus- und/oder -abfall sehr schnell reagiert und eine besonders hohe Datensicherheit gewährleistet werden. Die kontinuierliche Messung der Versorgungsspannung kann grundsätzlich eine ununterbrochene Messung bedeuten; von besonderem Vorteil ist bei der Erfindung aber eine kontinuierliche Messung in der Weise, dass eine regelmäßige, zyklische Messung der Versorgungsspannung, insbesondere des Datenspeichers oder der Datenverarbeitungseinrichtung, erfolgt. Es erfolgt so eine Spannungsmessung regelmäßig in bestimmten, gegebenenfalls veränderbaren, Zeitabständen.

Man könnte sich vorstellen, dass unmittelbar oberhalb der ersten Spannungsschwelle der Zugriff sowohl auf den ersten als auch den zweiten Speicherbereich frei ist. Jedoch ist es für eine weitere Erhöhung der Datensicherheit von besonderem Vorteil, wenn gemäß einer anderen Weiterbildung der Erfindung bei einer Versorgungsspannung oberhalb einer oberhalb der ersten Spannungsschwelle angeordneten, vorgegebenen zweiten Spannungsschwelle der Zugriff auf den ersten Speicherbereich und auf den zweiten Speicherbereich frei ist. Durch den Unterschied zwischen erster und zweiter Spannungsschwelle kann erreicht werden, dass bei einem Absinken der Versorgungsspannung ein niedrigerer Schwellwert, nämlich entsprechend der ersten Spannungsschwelle, vorliegt als bei einem Ansteigen der Versorgungsspannung, bei dem der Schwellwert der zweiten Spannungsschwelle entspricht (Hysterese). Insbesondere kann damit ein fortwährendes Sperren und Entsperren des Zugriffs auf den ersten Speicherbereich bei um die erste Spannungsschwelle schwankender Versorgungsspannung, insbesondere Versorgungsspannung des Datenspeichers oder der Datenverarbeitungseinrichtung, vermieden werden. Auch die zweite Spannungsschwelle kann - wie oben bezüglich der ersten Spannungsschwelle beschrieben - veränderbar, zum Beispiel einstellbar, sein.

Gemäß einer anderen vorteilhaften Weiterbildung der Erfindung wird ausgehend von einer Versorgungsspannung unterhalb der ersten Spannungsschwelle bei einem Ansteigen der Versorgungsspannung über die zweite Spannungsschwelle ein Software-Reset, den man auch als Programm-Rückstellung oder programmseitige Rückstellung bezeichnen kann, durchgeführt.

Von besonderem Vorteil bei einem Auftreten einer sehr niedrigen Versorgungsspannung oder deren kurzzeitigem Totalausfall ist es, wenn gemäß einer anderen Weiterbildung der Erfindung bei einem Absinken der Versorgungsspannung unter eine unterhalb der ersten Spannungsschwelle angeordnete, vorgegebene dritte Spannungsschwelle ein Hardware-Reset, den man auch als Geräte-Rückstellung oder geräteseitige Rückstellung bezeichnen kann, durchgeführt wird. Auch die dritte Spannungsschwelle kann - wie oben bezüglich der ersten Spannungsschwelle beschrieben - veränderbar, zum Beispiel einstellbar, sein; vorzugsweise ist sie jedoch durch die Hardware vorgegeben.

Eine zusätzliche Erhöhung der Datensicherheit kann gemäß einer anderen vorteilhaften Weiterbildung der Erfindung erreicht werden, wenn die Messung der Versorgungsspannung mit einher veränderbaren Messrate erfolgt. Auf diese Weise kann beispielsweise gezielt dann die Messrate, das heißt die Messfrequenz, erhöht werden, wenn mit einem unzulässigen Absinken der Versorgungsspannung, insbesondere der Versorgungsspannung des Datenspeichers oder der Datenverarbeitungseinrichtung, gerechnet werden muss. Andererseits kann die Messrate gering und damit das erfindungsgemäße Verfahren einfach gehalten werden, wenn die Versorgungsspannung erheblich über der ersten Spannungsschwelle liegt und somit seitens der Versorgungsspannung keine unmittelbare Gefahr für die Datensicherheit besteht.

Besonders vorteilhaft ist es, wenn gemäß einer Weiterbildung der Erfindung ausgehend von einer Versorgungsspannung oberhalb der ersten Spannungsschwelle und einem Absinken der Versorgungsspannung in Richtung der ersten Spannungsschwelle die Messung der Versorgungsspannung mit einer ansteigenden Messrate erfolgt. Vorzugsweise erfolgt somit dann eine Erhöhung der Messrate, wenn die gemessene Versorgungsspannung ausgehend von einer oberhalb der ersten Spannungsschwelle liegenden Versorgungsspannung in Richtung der ersten Spännungsschwelle absinkt und sich dieser annähert. Bevorzugt kann die Erhöhung der Messrate dabei automatisch erfolgen. Insbesondere um bei niedriger Versorgungsspannung die noch zur Verfügung stehende elektrische Energie möglichst effizient für die Sicherung gespeicherter Daten einsetzen zu können, sieht eine andere vorteilhafte Weiterbildung der Erfindung vor, dass die Messung der Versorgungsspannung bei einer Versorgungsspannung unterhalb der ersten Spannungsschwelle mit einer niedrigeren Messrate, das heißt längeren Zykluszeit, erfolgt als bei einer Versorgungsspannung oberhalb der zweiten Spannungsschwelle; das heißt bei einer Versorgungsspannung oberhalb der zweiten Spannungsschwelle liegt dann eine kürzere Zykluszeit vor.

Gemäß einer vorteilhaften Weiterbildung der Erfindung wird zur weiteren Erhöhung der Genauigkeit des erfindungsgemäßen Verfahrens die gemessene Versorgungsspannung als Mittelwert aus einer Mehrzahl von Versorgungsspannungsmessungen gebildet.

Die oben zweitgenannte Aufgabe wird bei einer Vorrichtung der eingangs genannten Art erfindungsgemäß dadurch gelöst, dass der Datenspeicher einen ersten Speicherbereich zur Speicherung von mit einer höheren Sicherheit zu schützenden Daten und einen zweiten Speicherbereich zur Speicherung von mit einer niedrigeren Sicherheit zu schützenden Daten aufweist und dass eine Spannungsmesseinrichtung zum Messen einer Versorgungsspannung zum Sperren eines Zugriffs auf den ersten Speicherbereich bei einer von der Spannungsmesseinrichtung gemessenen.Versorgungsspannung unterhalb einer ersten, vorgegebenen Spannungsschwelle vorgesehen ist.

Bevorzugt kann dabei die Spannungsmesseinrichtung eine Spannungsmesseinrichtung zum Messen einer Versorgungsspannung des Datenspeichers oder einer Datenverarbeitungseinrichtung der elektronischen Schaltung sein. Vorzugsweise kann eine Sperreinrichtung zum Sperren des Zugriffs auf den ersten Speicherbereich bei einer von der Spannungsmesseinrichtung gemessenen Versorgungsspannung unterhalb der ersten, vorgegebenen Spannungsschwelle vorgesehen sein. Besonders vorteilhaft ist ein Vorsehen der Spannungsmesseinrichtung bei der erfindungsgemäßen Vorrichtung in Verbindung mit der Sperreinrichtung, die den ersten Speicherbereich zum besonderen Schutz der darin enthaltenen Daten in Abhängigkeit von der mit der Spannungsmesseinrichtung gemessenen Versorgungsspannung, insbesondere der Versorgungsspannung des Datenspeichers oder der Datenverarbeitungseinrichtung, insbesondere eines Mikroprozessors oder Mikrocontrollers der Datenverarbeitungseinrichtung, sperrt. Mit Hilfe der Sperreinrichtung kann neben dem Sperren des ersten Speicherbereichs zudem auch eine Steuerung einer Freigabe des ersten und des zweiten Speicherbereichs erfolgen; die Sperreinrichtung kann dann allgemeiner eine Zugriffseinrichtung für den Datenspeicher bilden. Vorzugsweise kann der erste Speicherbereich ein Datensicherheit gewährleistender Speicherbereich und der zweite Speicherbereich ein Speicherbereich ohne Datensicherheit sein.

Vorteilhaft kann die erfindungsgemäße Vorrichtung einen besonders einfachen und betriebssicheren Aufbau aufweisen, wenn gemäß einer Weiterbildung der Erfindung die Spannungsmesseinrichtung einen AD-Wandler (Analog-Digital-Wandler) oder einen Hardware-Komparator zum Messen der Versorgungsspannung aufweist.

Es wäre denkbar, zur Steuerung der elektronischen Schaltung beispielsweise ein logisches Array oder Gatter vorzusehen. Jedoch kann ein einfacher, kostengünstiger Aufbau der elektronischen Schaltung und damit auch der erfindungsgemäßen Vorrichtung insgesamt dadurch erreicht werden, dass gemäß einer vorteilhaften Weiterbildung der Erfindung die elektronische Schaltung eine einen Mikroprozessor oder einen Mikrocontroller aufweisende zentrale Datenverarbeitungseinrichtung zur Steuerung einer den Datenspeicher und gegebenenfalls die Sperreinrichtung aufweisenden Datensammel- und Datenauswerteeinrichtung aufweist.

Ausführungsbeispiele der Erfindung werden anhand der beigefügten schematisierten Zeichnung im Folgenden näher beschrieben. Es zeigen:
- Figur 1A: eine Vorrichtung zur Durchführung eines Verfah- rens zur Steuerung eines Zugriffs auf einen Da- tenspeicher,
- Figur 1B: eine weitere Vorrichtung zur Durchführung des Verfahrens zur Steuerung eines Zugriffs auf einen Datenspeicher,
- Figur 2: ein Ablaufdiagramm für das Verfahren zur Steue- rung eines Zugriffs auf den Datenspeicher und
- Figur 3: einen Verlauf einer Versorgungsspannung des Da- tenspeichers oder der Datenverarbeitungseinrich- tung nach Figuren 1A, 1B über der Zeit.

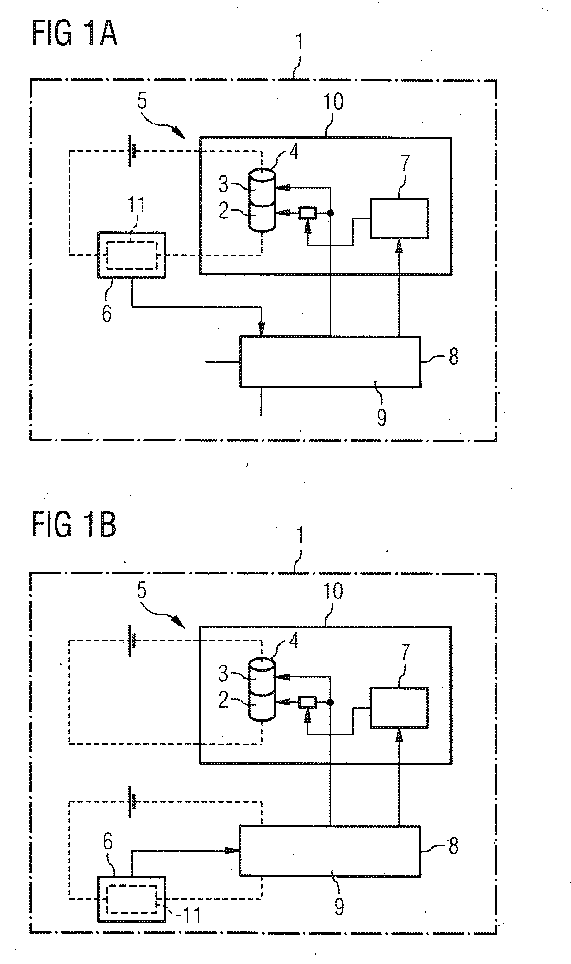

Sich jeweils entsprechende Elemente sind in allen Figuren mit gleichen Bezugszeichen versehen. Figur 1A zeigt eine beispielhaft als Tachograph 1 für ein Kraftfahrzeug ausgebildete Vorrichtung zur Durchführung eines Verfahrens zur Steuerung eines Zugriffs auf einen einen ersten Speicherbereich 2 und einen zweiten Speicherbereich 3 aufweisenden Datenspeicher 4 in einer elektronischen Schaltung 5, wobei Datenspeicher 4 und elektronische Schaltung 5 Bestandteil der Vorrichtung sind. Der erste Speicherbereich 2 des Datenspeichers 4 ist zur Speicherung von mit einer höheren Sicherheit zu schützenden Daten und der zweite Speicherbereich 3 zur Speicherung von mit einer niedrigeren Sicherheit zu schützenden Daten vorgesehen.

Weiterhin weist die Vorrichtung eine Spannungsmesseinrichtung 6 zum Messen einer Versorgungsspannung des Datenspeichers 4 auf, wobei die Spannungsmesseinrichtung 6 beispielsweise einen AD-Wandler 11 oder einen Hardware-Komparator aufweist. Ferner ist in diesem Beispiel zusätzlich eine Sperreinrichtung 7 zum Sperren eines Zugriffs auf den ersten Speicherbereich 2 bei einer von der Spannungsmesseinrichtung 6 gemessenen Versorgungsspannung unterhalb einer ersten, vorgegebenen Spannungsschwelle vorgesehen.

Die elektronische Schaltung 5 weist eine zentrale Datenverarbeitungseinrichtung 8 mit zum Beispiel einem Mikroprozessor 9 oder einem Mikrocontroller auf. Die zentrale Datenverarbeitungseinrichtung 8 dient unter anderem zur Steuerung einer den Datenspeicher 4 und die Sperreinrichtung 7 aufweisenden Datensammel- und Datenauswerteeinrichtung 10.

Eine Vorrichtung nach Figur 1B unterscheidet sich von der Vorrichtung nach Figur 1A lediglich dadurch, dass hier die Spannungsmesseinrichtung 6 zum Messen einer Versorgungsspannung der Datenverarbeitungseinrichtung 8, und zwar in diesem Ausführungsbeispiel speziell des Mikroprozessors 9 der Datenverarbeitungseinrichtung 8, vorgesehen ist.

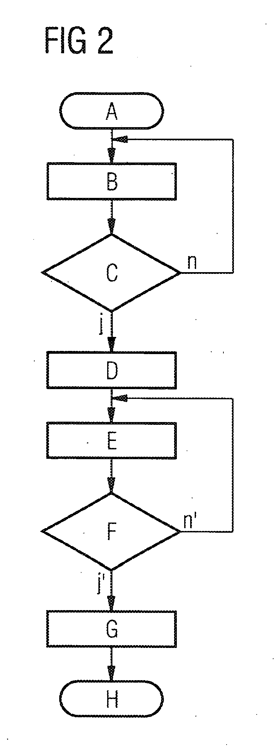

Figur 2 veranschaulicht anhand eines Ablaufdiagramms ein zum Beispiel für eine Vorrichtung, insbesondere einen Tachographen, nach Figuren 1A, 1B geeignetes Verfahren zur Steuerung eines Zugriffes auf einen einen ersten Speicherbereich und einen zweiten Speicherbereich aufweisenden Datenspeicher in einer elektronischen Schaltung. Dabei folgt nach einer einen Start des Verfahrens markierenden Grenzstelle A (Start) eine Operation B (Messen einer Versorgungsspannung), die eine Messung einer Versorgungsspannung, insbesondere des Datenspeichers oder der Datenverarbeitungseinrichtung, umfasst. Anschließend wird in einer Verzweigung C (Gemessene Versorgungsspannung unterhalb einer ersten Spannungsschwelle (untere Halt-Mode-Schwelle)?) beurteilt, ob die gemessene Versorgungsspannung unterhalb einer vorgegebenen ersten Spannungsschwelle liegt. Wenn das nicht der Fall ist, dann erfolgt gemäß einer zur Seite weisenden Ablauflinie n ein Sprung zurück, und die letzte Operation B wird erneut ausgeführt.

Liegt hingegen die gemessene Versorgungsspannung unterhalb der ersten Spannungsschwelle, so folgt gemäß einer nach unten weisenden Ablauflinie j eine weitere Operation D (Sperren Zugriff auf ersten Speicherbereich), die einen Zugriff auf den ersten Speicherbereich des Datenspeichers sperrt und beispielsweise auch ein Abschalten nicht zwingend benötigter Stromverbraucher der Vorrichtung, insbesondere des Tachographen, umfassen kann. Eine daran anschließende Operation E (Messen der Versorgungsspannung) umfasst wiederum eine Messung der Versorgungsspannung, insbesondere des Datenspeichers oder der Datenverarbeitungseinrichtung, woran anschließend in einer Verzweigung F (Gemessene Versorgungsspannung oberhalb einer zweiten Spannungsschwelle (obere Halt-Mode-Schwelle)?) beurteilt wird, ob die jetzt gemessene Versorgungsspannung_ oberhalb einer über der ersten Spannungsschwelle angeordneten, vorgegebenen zweiten Spannungsschwelle liegt.

Wenn das nicht der Fall ist, dann erfolgt gemäß einer zur Seite weisenden Ablauflinie n' ein Sprung zurück, und die letzte Operation E wird erneut ausgeführt. Ist hingegen die Bedingung der letztgenannten Verzweigung F erfüllt, so folgt gemäß einer nach unten weisenden Ablauflinie j' eine nächste Operation G (Software-Reset), die einen Software-Reset umfasst. Eine anschließende Grenzstelle H (Ende) markiert das Ende des Verfahrens.

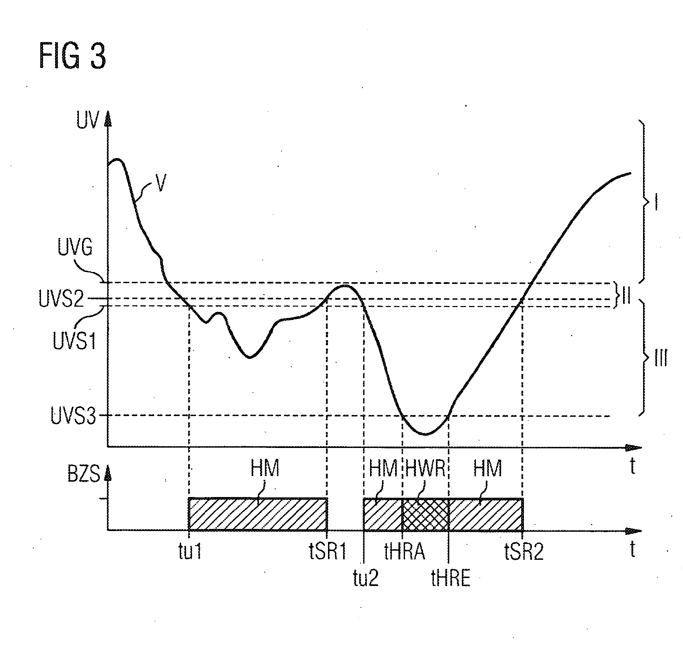

Ein beispielhafter Verlauf V der Versorgungsspannung UV des Datenspeichers 4 oder des Mikroprozessors 9 der Datenverarbeitungseinrichtung 8 (siehe Figuren 1A, 1B) über der Zeit t ist in Figur 3 dargestellt; außerdem ist in einem unteren Bereich der Figur 3 jeweils der mit der Versorgungsspannung UV zu einem bestimmten Zeitpunkt korrespondierende Betriebszustand BZS beispielsweise des oben beschriebenen Verfahrens zur Steuerung des Zugriffs auf den Datenspeicher gezeigt. Waagerechte Linien zeigen die Lage der ersten Spannungsschwelle UVS1, der zweiten Spannungsschwelle UVS2, die oberhalb der ersten Spannungsschwelle UVS1 angeordnet ist, und einer dritten Spannungsschwelle UVS3, die unterhalb der ersten Spannungsschwelle UVS1 angeordnet ist, an.

Bei einer Versorgungsspannung UV unterhalb der ersten Spannungsschwelle UVS1 ist der Zugriff auf den ersten Speicherbereich 2 (siehe Figuren 1A, 1B) gesperrt. Ein Sperren des Zugriffs auf den ersten Speicherbereich erfolgt mithin bei einem Absinken der Versorgungsspannung unter die erste Spannungsschwelle UVS1; dieses ist bei dem Ausführungsbeispiel nach Figur 3 zu zwei Zeitpunkten tu1, tu2 der Fall.

Weiterhin ist bei einer Versorgungsspannung UV oberhalb der zweiten Spannungsschwelle UVS2 der Zugriff auf den ersten Speicherbereich 2 und den zweiten Speicherbereich 3 frei. Ausgehend von einer Versorgungsspannung UV unterhalb der ersten Spannungsschwelle UVS1 wird bei einem Ansteigen der Versorgungsspannung UV über die zweite Spannungsschwelle UVS2 ein Software-Reset durchgeführt. In dem Ausführungsbeispiel nach Figur 3 ist das der Fall zu zwei Zeitpunkten tSR1, tSR2, wobei der erste Zeitpunkt tSR1 dieser Zeitpunkte tSR1, tSR2 nach dem ersten Zeitpunkt tu1, zu dem ein Sperren des ersten Speicherbereichs erfolgt, und vor dem zweiten Zeitpunkt tu2, zu dem ein erneutes Sperren des ersten Speicherbereichs erfolgt, liegt. Nach dem letztgenannten Zeitpunkt tu2 liegt der zweite Zeitpunkt tSR2, zu dem ein Software-Reset durchgeführt wird.

Bei einem Absinken der Versorgungsspannung UV unter eine unterhalb der ersten Spannungsschwelle UVS1 angeordnete dritte Spannungsschwelle UVS3 - in diesem Beispiel zu einem Zeitpunkt tHRA, der nach dem zweiten Zeitpunkt tu2, zu dem ein Sperren des ersten Speicherbereichs erfolgt, liegt - wird ein Hardware-Reset durchgeführt bis die Versorgungsspannung UV die dritte Spannungsschwelle UVS3 zu einem späteren Zeitpunkt tHRE, der hier vor dem zweiten Zeitpunkt tSR2, zu dem ein Software-Reset durchgeführt wird, liegt, wieder überschreitet.

Es hat sich gezeigt, dass die erste Spannungsschwelle UVS1 beispielsweise in einem Bereich von 6,6 V, die zweite Spannungsschwelle UVS2 zum Beispiel in einem Bereich von 7,2 V und die dritte Spannungsschwelle UVS3 zum Beispiel in einem Bereich von 5,8 V liegen kann.

Wie in Figur 3 veranschaulicht, kann die Versorgungsspannung, insbesondere des Datenspeichers oder der Datenverarbeitungseinrichtung, in einen unkritischen Bereich I, der dem normalen Betriebszustand entspricht, einen bedenklichen Bereich II und einen kritischen Bereich III, in dem der Betrieb des Datenspeichers nicht mehr sicher ist, eingeteilt werden. Die Versorgungsspannung UV liegt dann in dem unkritischen Bereich I, wenn sie größer ist als eine oberhalb der zweiten Spannungsschwelle UVS2 angeordnete Grenzspannung UVG. In dem bedenklichen Bereich II liegt die Versorgungsspannung UV, wenn sie bei sinkendem Spannungsverlauf kleiner ist als die Grenzspannung und größer als die erste Spannungsschwelle UVS1 sowie bei steigendem Spannungsverlauf größer als die zweite Spannungsschwelle UVS2 und kleiner als die Grenzspannung UVG. Darunter liegt je nach Verlauf der Versorgungsspannung der kritische Bereich III.

In dem unkritischen Bereich I kann zum Beispiel der AD-Wandler (siehe Figuren 1A, 1B) mit niedriger Messrate arbeiten, die jedoch bei Erreichen des bedenklichen Bereichs II wesentlich erhöht wird, um schnell bei plötzlichen Spannungsänderungen reagieren zu können. Beim Erreichen des bedenklichen Bereichs II werden stromintensive Bauteile der Vorrichtung, beispielsweise Beleuchtung und motorische Antriebe, ausgeschaltet, um intern gespeicherte elektrische Energie zu sparen. Beim Erreichen des kritischen Bereichs III tritt das die Vorrichtung steuernde Programm in eine Schleife entsprechend einem Halt-Mode ein, wobei die Schwelle zum kritischen Bereich III so zu wählen ist, dass noch hinreichend interne Energiereserven zum Eintritt in die Schleife vorhanden sind; andererseits sollte die Schwelle möglichst niedrig liegen, um einen langzeitigen Betrieb der elektronischen Schaltung zu gewährleisten. Innerhalb der Schleife wird nur noch ermittelt, ob die Versorgungsspannung die Schwelle vom kritischen Bereich III zum bedenklichen Bereich II wieder überschreitet. Dafür notwendige Speicherbereiche dürfen nicht in einem schützenswerten Speicherbereich, das heißt nicht in dem ersten Speicherbereich, des Massenspeichers, insbesondere batteriegepufferten RAM, liegen. Auch sind alle Interrupts gesperrt; sind zu einer Auswertung der Versorgungsspannung Interrupts erforderlich, so können diese weiterhin ausgeführt werden. Auch dabei gilt die Einschränkung, dass lediglich nicht schützenswerter Speicherbereich des Massenspeichers verwendet werden darf. Die Genauigkeit der Spannungsmessung kann gegebenenfalls durch Mittelwertbildung über eine Mehrzahl von Versorgungsspannungsmessungen verbessert werden, wobei zu berücksichtigen ist, dass kurze Messintervalle im aktuellen Betriebszustand keine große Bedeutung haben. Die Schleife wird entweder dadurch beendet, dass die Versorgungsspannung weiter sinkt und die elektrischen Komponenten, insbesondere der Datenspeicher und/oder die Datenverarbeitungseinrichtung, der elektronischen Schaltung nicht mehr arbeiten können, so dass ein durch Unterspannung bedingter Hardware-Reset ausgelöst wird, oder die Versorgungsspannung steigt wieder an und überschreitet eine Schwelle, die geringfügig höher liegt als die Eintrittsschwelle in den kritischen Bereich III. In diesem Fall wird ein Software-Reset durchgeführt, um ein definiertes Hochfahren der Vorrichtung mit der elektronischen Schaltung zu erzwingen. In einer Initialisierungsphase nach dem Software-Reset wird vorzugsweise zunächst wieder die Versorgungsspannung gemessen und bei kritischer Versorgungsspannung in die dem Halt-Mode entsprechende Schleife eingetreten. Auf diese Weise ist eine minimale Versorgungsspannung, insbesondere des Datenspeichers oder der Datenverarbeitungseinrichtung, definiert. Im Falle einer veränderbaren Messrate der Spannungsmessung beginnt die Initialisierungsphase mit einer hohen Messrate.

Für den Zeitraum des Hardware-Resets ist in dem unteren Bereich der Figur 3 ein entsprechender Betriebszustand HWR als kreuzschraffierte Fläche eingetragen. Für die Zeiträume, in denen der Zugriff auf den ersten Speicherbereich gesperrt ist, sind Betriebszustände HM als einfach schraffierte Fläche eingetragen.

Der Software-Reset betrifft ein die oben beschriebene Vorrichtung steuerndes Programm und erfolgt durch die Datenverarbeitungseinrichtung 8 (siehe Figuren 1A, 1B), insbesondere den Mikroprozessor 9, selbst. Beim Hardware-Reset wird hingegen die Datenverarbeitungseinrichtung 8, insbesondere der Mikroprozessor 9, selbst zurückgestellt; dieses kann beispielsweise dadurch geschehen, dass ein externer Spannungsregler eine zu niedrige Versorgungsspannung UV erkennt und ein entsprechendes Signal abgibt, das die Datenverarbeitungseinrichtung 8 zurückstellt. Vorzugsweise kann bei einem Hochfahren der Vorrichtung nach einem vollständigen Ausfall der Versorgungsspannung, insbesondere des Datenspeichers oder der Datenverarbeitungseinrichtung, die Spannungsmesseinrichtung 6 (siehe Figuren 1A, 1B), insbesondere der AD-Wandler 11, zunächst mit einer hohen Zykluszeit arbeiten, und danach kann, falls sich die Versorgungsspannung in dem kritischen Bereich befindet, in den Betriebszustand, in dem der Zugriff auf den ersten Speicherbereich gesperrt ist und das Programm in einer einem Halt-Mode entsprechenden Schleife, in der die Versorgungsspannung gemessen und mit den Spannungsschwelle verglichen wird, verharrt, eingetreten werden.

## Patentansprüche

1. Verfahren in einem Tachographen für ein Kraftfahrzeug zur Steuerung eines Zugriffs auf einen einen ersten Speicherbereich (2) und einen zweiten Speicherbereich (3) aufweisenden Datenspeicher (4) in einer elektronischen Schaltung,
- wobei der erste Speicherbereich (2) zur Speicherung von mit einer höheren Sicherheit zu schützenden Daten und der zweite Speicherbereich (3) zur Speicherung von mit einer niedrigeren Sicherheit zu schützenden Daten vorgesehen ist,
- wobei Daten in dem ersten Speicherbereich (2) eines höheren Schutzes gegen Beschädigung und/oder Zerstörung und/oder unkontrollierte Veränderung bedürfen als diejenigen des zweiten Speicherbereichs (3),
- wobei eine Versorgungsspannung (UV) gemessen wird,
- wobei die Messung der Versorgungsspannung (UV) mit einer veränderbaren Messrate erfolgt
- und wobei bei einer Versorgungsspannung (UV) unterhalb einer vorgegebenen ersten Spannungsschwelle (UVS1) der Zugriff auf den ersten Speicherbereich (2) gesperrt ist.

2. Verfahren nach Anspruch 1, **dadurch gekennzeichnet, dass** als Versorgungsspannung (UV) eine Versorgungsspannung (UV) des Datenspeichers (4) oder einer Datenverarbeitungseinrichtung (8) der elektronischen Schaltung (5) gemessen wird.

3. Verfahren nach Anspruch 1 oder 2, **dadurch gekennzeichnet, dass** die Versorgungsspannung (UV) kontinuierlich gemessen wird.

4. Verfahren nach einem der vorhergehenden Ansprüche, **dadurch gekennzeichnet, dass** bei einer Versorgungsspannung (UV) oberhalb einer oberhalb der ersten Spannungsschwelle (UVS1) angeordneten, vorgegebenen zweiten Spannungsschwelle (UVS2) der Zugriff auf den ersten Speicherbereich (2) und auf den zweiten Speicherbereich (3) frei ist.

5. Verfahren nach einem der vorhergehenden Ansprüche, **dadurch gekennzeichnet, dass** ausgehend von einer Versorgungsspannung (UV) unterhalb der ersten Spannungsschwelle (UVS1) bei einem Ansteigen der Versorgungsspannung (UV) über die zweite Spannungsschwelle (UVS2) ein Software-Reset durchgeführt wird.

6. Verfahren nach einem der vorhergehenden Ansprüche, **dadurch gekennzeichnet, dass** bei einem Absinken der Versorgungsspannung (UV) unter eine unterhalb der ersten Spannungsschwelle (UVS1) angeordnete, vorgegebene.dritte Spannungsschwelle (UVS3) ein Hardware-Reset durchgeführt wird.

7. Verfahren nach einem der vorhergehenden Ansprüche, **dadurch gekennzeichnet, dass** die Messung der Versorgungsspannung (UV) mit einer veränderbaren Messrate erfolgt.

8. Verfahren nach Anspruch 7, **dadurch gekennzeichnet, dass** ausgehend von einer Versorgungsspannung (UV) oberhalb der ersten Spannungsschwelle (UVS1) und einem Absinken der Versorgungsspannung (UV) in Richtung der ersten Spannungsschwelle (UVS1) die Messung der Versorgungsspannung (UV) mit einer ansteigenden Messrate erfolgt.

9. Verfahren nach Anspruch 7 oder 8, **dadurch gekennzeichnet, dass** die Messung der Versorgungsspannung (UV) bei einer Versorgungsspannung (UV) unterhalb der ersten Spannungsschwelle (UVS1) mit einer niedrigeren Messrate erfolgt als bei einer Versorgungsspannung (UV) oberhalb der zweiten Spannungsschwelle (UVS2).

10. Verfahren nach einem der vorhergehenden Ansprüche, **dadurch gekennzeichnet, dass** die gemessene Versorgungsspannung (UV) als Mittelwert aus einer Mehrzahl von Versorgungsspannungsmessungen gebildet wird.

11. Tachograph für ein Kraftfahrzeug zur Durchführung eines Verfahrens nach einem der vorhergehenden Ansprüche mit einer einen Datenspeicher (4) aufweisenden elektronischen Schaltung, wobei der Datenspeicher (4) einen ersten Speicherbereich (2) zur Speicherung von mit einer höheren Sicherheit zu schützenden Daten und einen zweiten Speicherbereich (3) zur Speicherung von mit einer niedrigeren Sicherheit zu schützenden Daten aufweist, wobei Daten in dem ersten Speicherbereich (2) eines höheren Schutzes gegen Beschädigung und/oder Zerstörung und/oder unkontrollierte Veränderung bedürfen als diejenigen des zweiten Speicherbereichs (3), wobei eine Spannungsmesseinrichtung (6) zum Messen einer Versorgungsspannung (UV) zum Sperren eines Zugriffs auf den ersten Speicherbereich (2) bei einer von der Spannungsmesseinrichtung (6) gemessenen Versorgungsspannung (UV) unterhalb einer ersten, vorgegebenen Spannungsschwelle (UVS1) vorgesehen ist, wobei die Messung der Versorgungsspannung (UV) mit einer veränderbaren Messrate erfolgt.

12. Vorrichtung nach Anspruch 11, **dadurch gekennzeichnet, dass** die Spannungsmesseinrichtung (6) eine Spannungsmesseinrichtung (6) zum Messen einer Versorgungsspannung (UV) des Datenspeichers (4) oder einer Datenverarbeitungseinrichtung (8) der elektronischen Schaltung (5) ist.

13. Vorrichtung nach Anspruch 11 oder 12, **dadurch gekennzeichnet, dass** eine Sperreinrichtung (7) zum Sperren des Zugriffs auf den ersten Speicherbereich (2) bei einer von der Spannungsmesseinrichtung (6) gemessenen Versorgungsspannung (UV) unterhalb der ersten, vorgegebenen Spannungsschwelle (UVS1) vorgesehen ist.

14. Vorrichtung nach einem der Ansprüche 11 bis 13, **dadurch gekennzeichnet, dass** die Spannurigsmesseinrichtung (6) einen AD-Wandler (11) oder einen Hardware-Komparator zum Messen der Versorgungsspannung (UV) aufweist.

15. Vorrichtung nach einem der Ansprüche 11 bis 14, **dadurch gekennzeichnet, dass** die elektronische Schaltung (5) eine einen Mikroprozessor (9) oder einen Mikrocontroller aufweisende zentrale Datenverarbeitungseinrichtung (8) zur Steuerung einer den Datenspeicher (4) und gegebenenfalls die Sperreinrichtung (7) aufweisenden Datensammel- und Datenauswerteeinrichtung (10) aufweist.

## Claims

1. Method in a tachograph for a motor vehicle for controlling access to a data store (4), which has a first memory area (2) and a second memory area (3), in an electronic circuit,
- wherein the first memory area (2) is provided for the purpose of storing data to be protected with a relatively high level of security and the second memory area (3) is provided for the purpose of storing data to be protected with a relatively low level of security,
- wherein data in the first memory area (2) require a higher level of protection against damage and/or destruction and/or uncontrolled alteration than those in the second memory area (3),
- wherein a supply voltage (UV) is measured,
- wherein the supply voltage (UV) is measured at an alterable measurement rate and
- wherein when the supply voltage (UV) is below a prescribed first voltage threshold (UVS1) the access to the first memory area (2) is blocked.

2. Method according to Claim 1, **characterized in that** the supply voltage (UV) measured is a supply voltage (UV) for the data store (4) or for a data processing device (8) in the electronic circuit (5).

3. Method according to Claim 1 or 2, **characterized in that** the supply voltage (UV) is measured continuously.

4. Method according to one of the preceding claims, **characterized in that** when the supply voltage (UV) is above a prescribed second voltage threshold (UVS2), which is arranged above the first voltage threshold (UVS1), the access to the first memory area (2) and to the second memory area (3) is unrestricted.

5. Method according to one of the preceding claims, **characterized in that**, assuming that the supply voltage (UV) is below the first voltage threshold (UVS1), a software reset is performed if the supply voltage (UV) rises above the second voltage threshold (UVS2).

6. Method according to one of the preceding claims, **characterized in that** a hardware reset is performed if the supply voltage (UV) drops below a prescribed third voltage threshold (UVS3), which is arranged below the first voltage threshold (UVS1).

7. Method according to one of the preceding claims, **characterized in that** the supply voltage (UV) is measured at an alterable measurement rate.

8. Method according to Claim 7, **characterized in that**, assuming that the supply voltage (UV) is above the first voltage threshold (UVS1) and that the supply voltage (UV) drops toward the first voltage threshold (UVS1), the supply voltage (UV) is measured at a rising measurement rate.

9. Method according to Claim 7 or 8, **characterized in that** the supply voltage (UV) is measured at a lower measurement rate when the supply voltage (UV) is below the first voltage threshold (UVS1) than when the supply voltage (UV) is above the second voltage threshold (UVS2).

10. Method according to one of the preceding claims, **characterized in that** the measured supply voltage (UV) is formed as a mean value from a plurality of supply voltage measurements.

11. Tachograph for a motor vehicle for carrying out a method according to one of the preceding claims with an electronic circuit which has a data store (4), wherein the data store (4) has a first memory area (2) for storing data to be protected with a relatively high level of security and a second memory area (3) for storing data to be protected with a relatively low level of security wherein data in the first memory area (2) require a higher level of protection against damage and/or destruction and/or uncontrolled alteration than those in the second memory area (3), wherein a voltage measuring device (6) is provided for the purpose of measuring a supply voltage (UV) for blocking access to the first memory area (2) when a supply voltage (UV) measured by the voltage measuring device (6) is below a first, prescribed voltage threshold (UVS1), wherein the supply voltage (UV) is measured at an alterable measurement rate.

12. Apparatus according to Claim 11, **characterized in that** the voltage measuring device (6) is a voltage measuring device (6) for measuring a supply voltage (UV) for the data store (4) or for a data processing device (8) in the electronic circuit (5).

13. Apparatus according to Claim 11 or 12, **characterized in that** a blocking device (7) is provided for the purpose of blocking the access to the first memory area (2) when a supply voltage (UV) measured by the voltage measuring device (6) is below the first, prescribed voltage threshold (UVS1).

14. Apparatus according to one of Claims 11 to 13, **characterized in that** the voltage measuring device (6) has an AD converter (11) or a hardware comparator for measuring the supply voltage (UV).

15. Apparatus according to one of Claims 11 to 14, **characterized in that** the electronic circuit (5) has a central data processing device (8), which has a microprocessor (9) or a microcontroller, for controlling a data collection and data evaluation device (10) which has the data store (4) and possibly the blocking device (7).

## Revendications

1. Procédé pour commander, dans un tachygraphe pour véhicule automobile, l'accès à une mémoire de données (4) dans un circuit électronique, la mémoire de données comportant une première zone de mémorisation (2) et une deuxième zone de mémorisation (3),
- où la première zone de mémorisation (2) est prévue pour mémoriser des données à protéger avec un niveau élevé de sécurité et la deuxième zone de mémorisation (3), pour mémoriser des données à protéger avec un niveau plus faible de sécurité,
- où des données stockées dans la première zone de mémorisation (2) nécessitent une protection plus élevée contre une détérioration et/ou une destruction et/ou une modification non contrôlée que les données stockées dans la deuxième zone de mémorisation (3),
- où une tension d'alimentation (UV) est mesurée,
- où la mesure de la tension d'alimentation (UV) est effectuée avec un taux de mesure variable
- et où, dans le cas où la tension d'alimentation (UV) est inférieure à un premier seuil de tension (UVS1) donné, l'accès à la première zone de mémorisation (2) est bloqué.

2. Procédé selon la revendication 1, **caractérisé par le fait que**, en tant que tension d'alimentation (UV), c'est une tension d'alimentation (UV) de la mémoire de données (4) ou d'un dispositif (8) de traitement de données du circuit électronique (5) qui est mesurée.

3. Procédé selon la revendication 1 ou 2, **caractérisé par le fait que** la tension d'alimentation (UV) est mesurée d'une façon continue.

4. Procédé selon l'une des revendications précédentes, **caractérisé par le fait que**, dans le cas où une tension d'alimentation (UV) est supérieure à un deuxième seuil de tension (UVS2) donné supérieur au premier seuil de tension (UVS1), l'accès à la première zone de mémorisation (2) et à la deuxième zone de mémorisation (3) est libre.

5. Procédé selon l'une des revendications précédentes, caractérise p a r le fait que, lors d'une augmentation de la tension d'alimentation (UV) partant d'une tension d'alimentation (UV) inférieure au premier seuil de tension (UVS1) et dépassant le deuxième seuil de tension (UVS2), il est procédé à un redémarrage à chaud du logiciel.

6. Procédé selon l'une des revendications précédentes, **caractérisé par le fait que**, lors d'une diminution de la tension d'alimentation (UV) au-dessous d'un troisième seuil de tension (UVS3) donné inférieur au premier seuil de tension (UVS1), il est procédé à un redémarrage à chaud du matériel.

7. Procédé selon l'une des revendications précédentes, **caractérisé par le fait que** la mesure de la tension d'alimentation (UV) est effectuée avec un taux de mesure variable.

8. Procédé selon la revendication 7, **caractérisé par le fait que**, lors d'une diminution de la tension d'alimentation (UV) partant d'une tension d'alimentation (UV) supérieure au premier seuil de tension (UVS1) et allant en direction du premier seuil de tension (UVS1), la mesure de la tension d'alimentation (UV) est effectuée avec un taux de mesure de plus en plus élevé.

9. Procédé selon la revendication 7 ou 8, **caractérisé par le fait que**, dans le cas où la tension d'alimentation (UV) est inférieure au premier seuil de tension (UVS1), la mesure de la tension d'alimentation (UV) est effectuée avec un taux de mesure plus faible que dans le cas où la tension d'alimentation (UV) est supérieure au deuxième seuil de tension (UVS2).

10. Procédé selon l'une des revendications précédentes, **caractérisé par le fait que** la tension d'alimentation (UV) mesurée est formée par la valeur moyenne d'une pluralité de mesures de la tension d'alimentation.

11. Tachygraphe pour véhicule automobile permettant d'exécuter un procédé conforme à l'une des revendications précédentes, ledit tachygraphe comportant un circuit électronique équipé d'une mémoire de données (4), où ladite mémoire de données (4) comporte une première zone de mémorisation (2) prévue pour mémoriser des données à protéger avec un niveau élevé de sécurité et une deuxième zone de mémorisation (3) prévue pour mémoriser des données à protéger avec un niveau plus faible de sécurité, où des données stockées dans la première zone de mémorisation (2) nécessitent une protection plus élevée contre une détérioration et/ou une destruction et/ou une modification non contrôlée que les données mémorisées dans la deuxième zone de mémorisation (3), où il est prévu un dispositif de mesure de tension (6) permettant de mesurer une tension d'alimentation (UV) en vue de bloquer l'accès à la première zone de mémorisation (2) dans le cas où la tension d'alimentation (UV) mesurée par le dispositif de mesure de tension (6) est inférieure à un premier seuil de tension (UVS1) donné, la mesure de la tension d'alimentation (UV) étant effectuée avec un taux de mesure variable.

12. Dispositif selon la revendication 11, **caractérisé par le fait que** le dispositif de mesure de tension (6) est un dispositif de mesure de tension (6) permettant de mesurer une tension d'alimentation (UV) de la mémoire de données (4) ou d'un dispositif de traitement de données (8) du circuit électronique (5).

13. Dispositif selon la revendication 11 ou 12, **caractérisé par le fait qu'**il est prévu un système de blocage (7) permettant de bloquer l'accès à la première zone de mémorisation (2) dans le cas où la tension d'alimentation (UV) mesurée par le dispositif de mesure de tension (6) est inférieure au premier seuil de tension (UVS1) donné.

14. Dispositif selon la revendication 11 à 13, **caractérisé par le fait que** le dispositif de mesure de tension (6) comporte un convertisseur analogique/numérique (11) ou un comparateur de matériel permettant de mesurer la tension d'alimentation (UV).

15. Dispositif selon la revendication 11 à 14, **caractérisé par le fait que** le circuit électronique (5) comporte un dispositif central de traitement de données (8) avec un micro-processeur (9) ou un microcontrôleur permettant de commander un dispositif (10) de collectionnement et d'analyse de données comportant la mémoire de données (4) et, le cas échéant, le dispositif de blocage (7).
